# EUROPEAN PATENT SPECIFICATION

(11) **EP 4 312 252 B1**
(45) Date of publication and mention of the grant of the patent: **20.11.2024**
(21) Application number: 22187143.7
(22) Date of filing: 27.07.2022
(51) Int. Cl.: H01L 21/768

(54) **A METHOD FOR FORMING AN INTERCONNECT STRUCTURE**
VERFAHREN ZUR HERSTELLUNG EINER VERBINDUNGSSTRUKTUR
PROCÉDÉ DE FORMATION D'UNE STRUCTURE D'INTERCONNEXION

(43) Date of publication of application: 31.01.2024
(73) Proprietor: Imec VZW, 3001 Leuven (BE)
(72) Inventor: Li, Waikin, 3000 Leuven (BE); Tao, Zheng, 3001 Heverlee (BE)
(74) Representative: AWA Sweden AB

(56) References cited:
- US-A- 5 512 514
- US-A1- 2020 350 206
- US-B1- 6 242 342

## Description

### Technical field

The present disclosure relates to a method for forming an interconnect structure for an integrated circuit.

### Background

Modern circuit fabrication includes processes for forming electrical interconnection structures for interconnecting active and passive devices in a functioning integrated circuit. An interconnection structure may include one or more interconnection levels or tiers, which are formed above a semiconductor substrate. An interconnection level includes horizontal metal paths or lines arranged in an insulating material layer. Metal lines of different interconnection levels may be interconnected by metal vias extending vertically through the insulating layers.

In conventional circuit fabrication, an interconnection level may be formed in what in the art is known as a "dual damascene process". According to this approach, horizontally extending trenches are etched in the insulating layer. Further, vertically extending via holes are formed in the insulating layer. Thereafter the trenches and via holes are simultaneously filled with metal to form lines in the trenches and vias in the via holes.

More recently, an alternative approach which may be referred to as a "semi-damascene process" has been proposed wherein metal lines instead are directly etched in a metal layer. Via holes for vias connecting successive interconnect layers are patterned in a dielectric layer in a single-damascene fashion, then overfilled with metal such that a metal layer is formed over the dielectric layer. This metal layer is then masked and etched to form the metal lines.

US5512514 A, US6242342 B1 and US2020/350206 A1 disclose prior art methods of forming subtractive, self-aligned line-and-via patterns.

### Summary

While the semi-damascene flow removes the need for a chemical mechanical polishing (CMP) of the metal layer, which typically forms part of the dual damascene process, involves two separate lithography and etching process steps ("litho-etch"), one for the via hole patterning and one for the direct metal layer etch. There is hence still room for more efficient processes for forming interconnect structures.

In light of the above, it is an objective to provide a method for forming an interconnect structure for an integrated circuit which enables forming of horizontal metal lines and vertical metal vias (i.e. metal pillars) in an efficient and reliable manner. Further and alternative objectives may be understood from the following.

According to an aspect of the present inventive concept, there is provided a method for forming an interconnect structure for an integrated circuit, the method comprising:
forming a metal layer over a substrate;
forming a hard mask layer over the metal layer;
forming a first resist layer of a first resist material over the hard mask layer and patterning the first resist layer in a first lithography process to define a first resist pattern;
forming over the first resist pattern a second resist layer of a second resist material different from the first resist material and patterning the second resist layer in a second lithography process to define a second resist pattern of resist lines extending in parallel along a first direction, wherein at least a portion of the first resist pattern is overlapped by the second resist pattern;
patterning the hard mask layer using the second resist pattern as an etch mask to define a hard mask line pattern underneath the second resist pattern, and subsequently the metal layer to define a metal line pattern underneath the hard mask line pattern;
removing the second resist pattern and subsequently patterning the hard mask line pattern using said at least a portion of the first resist pattern as an etch mask to define a hard mask pillar pattern over the metal line pattern; and
forming a metal pillar pattern in accordance with the hard mask pillar pattern.

The method aspect enables forming a metal line pattern and a metal pillar/via pattern using a first and a second resist pattern. Similar to the above-discussed conventional semi-damascene process, the metal lines are according to the present method etched in a metal layer ("direct metal etch", DME). However in contrast, rather than forming vias by filling via holes patterned in an insulating layer prior to the DME, metal pillars may according to the present method be formed on top of the metal lines using a hard mask pillar pattern defined using the first and second resist patterns. Compared to the "litho-etch-litho-etch" sequence of the conventional semi-damascene process, the present method hence enables a "litho-litho-etch" process.

The method is enabled by the use of dual resist layers, i.e. the first and second resist layers formed of different resist materials. The first and second resist layers and respective resist patterns may thus be selectively processed (e.g. lithographically patterned and etched) with respect to each other. In particular, the second resist pattern may be used as an etch mask for the first resist pattern such that portions of the first resist pattern not overlapped by the second resist pattern ("non-overlapped first resist pattern portions") may be removed selectively to the second resist pattern. Conversely, the second resist pattern may be removed selectively to the first resist pattern.

The metal pillar pattern is formed in accordance with the hard mask pillar pattern, i.e. using the hard mask pillar pattern. As the hard mask pillar pattern is defined by the portions of the first resist pattern overlapped by the resist lines of the second resist pattern, the metal pillars of the pattern may be self-aligned with the metal lines of the metal line pattern. Different approaches for forming the metal pillar pattern are possible, both metal line etch back (using the hard mask pillar pattern as an etch mask), and a damascene type approach (filling pillar/via holes formed an insulating layer using the hard mask pillar pattern in a tone-inversion approach).

As used herein, the term "line" (e.g. as in "resist line" and "metal line") refers to an elongated feature (e.g. of resist material or metal) with a longitudinal dimension oriented along the substrate (e.g. along the first direction).

Terms such as "over", "underneath", "vertical", "upper", "lower", "top", "bottom", "stacked on top of", are herein to be understood as denoting locations or orientations within a frame of reference of the substrate. In particular, the terms may be understood as locations or orientations along a normal direction to the substrate. Correspondingly, terms such as "horizontal" and "lateral" are to be understood as locations or orientations parallel to the substrate, i.e. parallel to an upper surface or the main plane of extension of the substrate.

In some embodiments, the first resist material may be a metal-comprising resist material, and the second resist material may be an organic resist material, or vice versa. This combination of resist materials facilitate individual processing with a favorable degree of selectivity. The organic resist material may in particular be a chemically amplified resist material. Advantageously, the first resist material may be a metal-comprising resist material, and the second resist material is an organic resist material. The second resist layer may be formed with a greater thickness than the first resist layer.

In some embodiments, only a portion of the first resist pattern is overlapped by the second resist pattern. This allows the first resist pattern to be patterned at relaxed horizontal dimensions (as seen in a horizontal plane parallel to the substrate) compared to the metal pillars of the metal pillar pattern, since metal pillars may be defined at positions where the second resist pattern forms defines overlap with the first resist pattern.

In some embodiments, the method may further comprise patterning the first resist pattern using the second resist pattern as an etch mask. The method may accordingly comprise patterning both the first resist pattern and the hard mask layer using the second resist pattern as an etch mask. The non-overlapped portions of the first resist pattern may hence be removed prior to proceeding with patterning the metal layers

In some embodiments, the first resist pattern may comprise a pattern of resist pillars, and wherein the second resist layer may be patterned such that at least a portion of each resist pillar is overlapped by a resist line of the second resist pattern.

Accordingly, a pattern of resist pillars for defining locations for metal pillars may be formed and subsequently be overlapped with resist lines of the second resist pattern. A resist pillar of the first resist pattern may be completely overlapped by a resist line of the second resist pattern. Alternatively, a resist pillar of the first resist pattern may be only partly overlapped by a resist line of the second resist pattern. In line with the above discussion, non-overlapped portions of a resist pillar may then be removed prior to proceeding with patterning the hard mask and metal layers. This allows the first resist layer to be patterned to define resist pillars with relaxed horizontal dimensions compared to the final metal pillars of the metal pillar pattern.

In some embodiments, the first resist pattern may comprise a pattern of resist bars extending in parallel along a second direction transverse to the first direction, and wherein the second resist layer may be patterned such that each respective resist bar of the first resist pattern is overlapped by at least two resist lines of the second resist pattern.

Accordingly, only a portion of the first resist pattern is overlapped by the second resist pattern. More specifically, each resist bar may be overlapped by at least two parallel resist lines of the second resist pattern. The metal pillars may hence be aligned with each other as seen along the second direction. This enables a two defining two metal pillars at a same horizontal location along a pair of parallel metal lines of the metal line pattern. The two metal pillars may in a precise and reproducible manner be formed directly opposite each other on a respective metal line.

As used herein, the term "bar" to an elongated feature (e.g. of the second resist material) with a longitudinal dimension oriented along the substrate (e.g. along the second direction). The resist bars may hence like the features of the second resist pattern be referred to as resist lines (albeit oriented transverse to the resist lines of the second resist pattern). The longitudinal dimension of the resist bars of the first resist pattern may however typically be smaller than the longitudinal dimensions of the resist lines of the second resist pattern.

In some embodiments, forming the metal pillar pattern may comprise partially etching back the metal line pattern using said at least a portion of the first resist pattern and/or the hard mask pillar pattern as an etch mask.

Both the metal pillars and the metal lines may hence be formed in a DME approach. A pattern of metal pillars (forming the vertical interconnects) may hence be formed on top of metal lines of the partially etched back metal line pattern.

The first resist pattern may optionally be removed prior to the metal line pattern etch back, wherein the hard mask pillar pattern may be used as an etch mask during the metal line pattern etch back.

In some embodiments, the method may further comprise forming an insulating layer surrounding the metal line pattern and the hard mask pillar pattern, and wherein forming the metal pillar pattern may comprise removing the hard mask pillar pattern to form pillar openings in the insulating layer, and depositing a second metal layer in the pillar openings.

The metal pillars (forming the vertical interconnects) may accordingly be formed by in a damascene style approach. As the pillar openings are formed in a tone inversion approach by removing the hard mask pillar pattern, the pillar openings and the metal pillars may be self-aligned with the metal lines.

In some embodiments, the method may further comprise surrounding said at least a portion of the first resist pattern with the insulating layer and removing both the hard mask pillar pattern and said at least a portion of the first resist pattern to form the pillar openings in the insulating layer.

The pillar openings and the metal pillars may hence be formed with a vertical dimension (height) corresponding to a combined vertical dimension (height or thickness) of the hard mask pillar pattern and the first resist pattern.

Alternatively, the first resist pattern may optionally be removed prior to forming the insulating layer, in case the vertical dimension of the hard mask pillar pattern is of a sufficient height.

In some embodiments, the first resist pattern may comprise a first sub-pattern of resist lines extending in parallel along the first direction, and a second sub-pattern of second resist features. The second resist layer may be patterned such that each respective resist line of the first sub-pattern, along at least a part of its length, is overlapped by a respective first resist line of the second resist pattern, and such that at least a portion of each second resist feature of the second sub-pattern is overlapped by a respective second resist line of the second resist pattern.

Thereby, said at least a portion of the first resist pattern used as the etch mask when patterning the hard mask line pattern may comprise: said at least a part of each resist line of the first sub-pattern and said at least a portion of each second resist feature of the second sub-pattern.

The method may further comprise, subsequent to removing the second resist pattern, patterning the hard mask line pattern using said at least a portion of the first resist pattern (i.e. said at least a part of each resist line of the first sub-pattern and said at least a portion of each second resist feature of the second sub-pattern) as an etch mask to define a combined hard mask pillar-and-line pattern over the metal line pattern, and subsequently partially etching back the metal line pattern using said at least a portion of the first resist pattern and/or the combined hard mask pillar-and-line pattern as an etch mask.

The first and second sub-pattern of the first resist pattern hence enables a combined hard mask pillar-and-line pattern to be formed, comprising a first sub-pattern of hard mask lines and a second sub-pattern of hard mask pillars.

Accordingly, a pattern of parallel metal lines comprising partially etched back and non-etched back metal lines may be formed, wherein a pattern of metal pillars are be formed on top of the partially etched back metal lines. More specifically, a metal line of a first height ("greater height) may be formed at positions defined by the first sub-pattern of the first resist pattern and the first resist lines of the second resist pattern while a metal line of a second height ("reduced height") smaller than the first height may be formed at positions defined by the second resist lines of the second resist pattern. Meanwhile, the second sub-pattern of second resist features of the first resist pattern may be used to define locations of the metal pillars of the metal pillar pattern on top of the reduced height metal lines.

A line height of the metal lines may hence varied between and/or along metal lines. This RC performance to be improved along selected metal lines o the metal line pattern.

The second sub-pattern may either be a pattern of resist pillars, or a pattern of resist bars extending in parallel along a second direction transverse to the first direction. For a discussion of respective details and merits related to resist pillars and resist bars, reference is made to above discussion of embodiments comprising resist pillars or resist bars.

### Brief description of the drawings

The above, as well as additional objects, features and advantages, may be better understood through the following illustrative and non-limiting detailed description, with reference to the appended drawings. In the drawings like reference numerals will be used for like elements unless stated otherwise.
Figures 1a-b to 4a-b and 5 illustrate a method for forming an interconnection structure according to an embodiment.
Figures 6a-b to 9a-b and 10 illustrate a method for forming an interconnection structure according to another embodiment.
Figures 11a-b to 13a-b illustrate a method for forming an interconnection structure according to another embodiment.
Figures 14 to 18 illustrate a method for forming an interconnection structure according to another embodiment.

### Detailed description

Various embodiments of a method for forming an interconnect structure for an integrated circuit in accordance with an aspect of the present inventive concept will in the following be described with reference to the drawings. A common denominator of the method embodiments is the forming of a first resist pattern in a first lithography process and a second resist pattern in a second lithography process, and using the second resist pattern to define a hard mask line pattern in a hard mask layer and a metal line pattern in a metal layer, and after removing the second resist pattern using the first resist pattern (after optionally being patterned using the second resist pattern) to form a metal pillar pattern for the metal line pattern.

As will be further set forth herein, the first resist pattern (which may comprise a resist pillar or resist bar pattern) is formed by patterning a first resist layer of a first resist material in a first lithography process. The second resist pattern (comprising a resist line pattern) is formed by patterning a second resist layer of a second different resist material in a second lithography process. The first and second resist materials are selected to be so that the first resist material and the second resist material are etchable selectively to each other. That is, the first and second resist materials are selected such that an etch rate (i.e. material removal rate) of the first resist material exceeds an etch rate of the second resist material when the first and second resist materials are subjected to a first etching process, and conversely such that an etch rate of the second resist material exceeds an etch rate of the first resist material when the first and second resist materials are subjected to a second etching process. The respective etch selectivity of the first and second materials should hereby be understood to refer to the etch selectivity after the first and second materials having been subjected to the respective first and second lithography processes. Each one of the first and second lithography processes may comprise processing which per se is well known in the art, such as an exposure step and a development step. For instance, extreme ultraviolet lithography (EUVL) may be used to define a tight pitch pattern in a photoresist layer but the type of lithography technique may more generally be selected in accordance with the dimensions of the target pattern. As may be appreciated by the skilled person the first and second lithography processes may be supplemented with further steps such as a soft bake prior to exposure, a post-exposure bake and a post-development hard bake. Positive as well as negative resists are possible. The first resist material may be a metal-comprising resist material such as a metal-oxide resist. The second resist material may be an organic resist material such as a chemically amplified resist (CAR). This combination of resist materials lends itself favorably to mutually selective processing of the first and second resist materials of the respective resist patterns. For instance, a ratio of etch rates of metal-comprising resist to CAR of 10:1 or greater may be achieved, and similarly for CAR to metal-comprising resist. However, it is contemplated that the method more generally be used also with other combinations of first and second resist materials allowing selective processing as set forth herein.

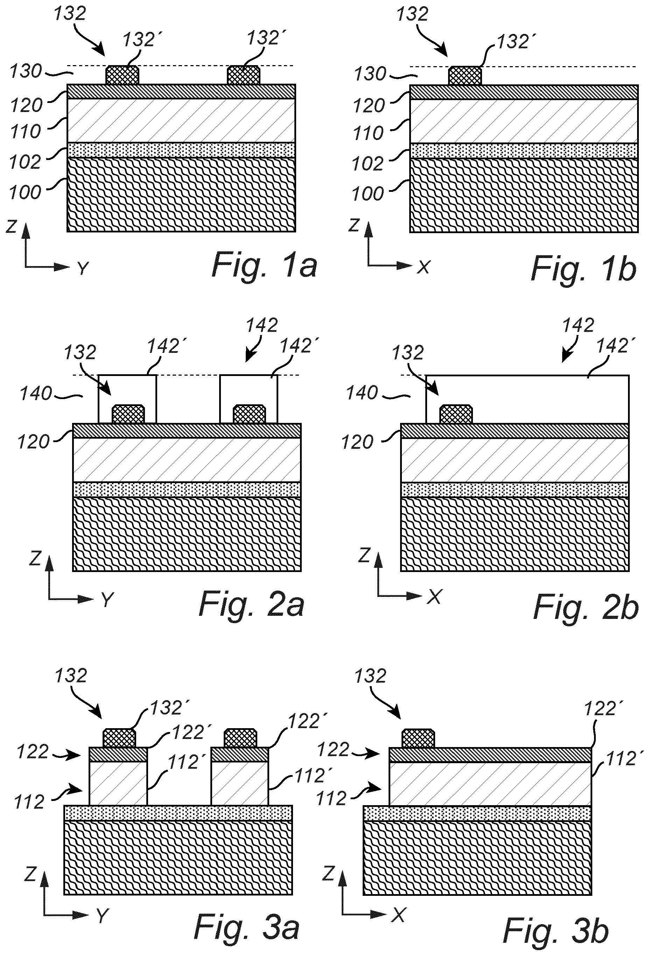

A method for forming an interconnection structure according to a first embodiment will now be disclosed with reference to Figs. 1a-b to 4a-b and 5. Figs. 1a to 4a depict a first cross section (parallel to the YZ plane) of a device structure (e.g. an integrated circuit) at various stages of the method while Figs. 1b to 4b depict a second cross section (parallel to the XZ plane). Axis X and axis Y indicate respectively first and second horizontal directions while axis Z indicate a vertical direction.

Figs. 1a-b depict a substrate 100. The substrate 100 may be semiconductor substate of a conventional type, for instance a semiconductor substrate such as a silicon (Si) substrate, a silicon-on-insulator (SOI) substrate, a germanium (Ge) substrate, a SiGe substrate etc. An active device layer including active devices (e.g. semiconductor devices such as transistors) may be fabricated on a main surface of the substrate 100. Layer 102 represents an insulating capping layer which may be formed over the active device layer prior to forming the interconnect structure.

A metal layer 110 has been formed over the substrate 100, e.g. on the capping layer 102. The metal layer 110 may for example be formed of a layer of Ru, Mo, W, Al, Co or TiN, or a combination of two or more of such layers. The metal layer 110 may be deposited using conventional deposition processes such as physical vapor deposition (PVD), chemical vapor deposition (CVD) or atomic layer deposition (ALD).

A hard mask layer 120 has further been formed over the metal layer 110, e.g. on top of the metal layer 120. The hard mask layer 120 may comprise a hard mask material such as an oxide, nitride or carbide, for instance SiOₓ, SiN, SiCN, SiOC, or an amorphous carbon film.

A first resist layer 130 has been formed over the hard mask layer 120. The first resist layer 130 is formed of a first resist material, such as a metal-comprising resist material or any of the other examples of first resist materials discussed above.

While not individually shown, the deposition of the first resist material may be preceded by forming of one of more further layers a single layer, the hard mask layer 120 may more generally comprise a stack of intermediate layers, such as, one or more anti-reflective coatings such as SiOC layers, spin-on-glass (SOG) layers and a planarization layer such as an organic spin-on layer, e.g. a spin-on-carbon (SOC) layer.

As further indicated in Figs. 1a-b, the first resist layer 130 (dashed line) has been patterned using a first lithography process to define a first resist pattern 132 in the form of a pattern of resist pillars 132'. As will be understood from the following, the positions of the resist pillars 132' of the resist pattern 132 define the positions (as seen in the horizontal plane XY) of the metal pillars of the interconnect structure which are to be formed. The resist pillars 132' may e.g. be formed with a rounded or rectangular shape (as seen along the Z direction).

In Figs. 2a-b, a second resist layer 140 has been formed over the first resist pattern 132 and then patterned using a second lithography process to define a second resist pattern 142 in the form of a pattern of resist lines 142' extending in parallel along the first direction X. The second resist layer 140 is formed of a second resist material, such as a CAR material or any of the other examples of second resist materials discussed above. As indicated in the illustrated embodiment, the second resist layer 140 may be formed with a greater thickness (along the Z direction) than the first resist layer 130.

The second resist pattern 142 is formed such that each resist pillar 132' of the first resist pattern 132 is overlapped by a resist line 142' of the second resist pattern 142. As will be understood from the following, the positions of the resist lines 142' of the resist pattern 142 define the positions (as seen in the horizontal plane XY) of the metal lines of the interconnect structure which are to be formed. The positions where the resist lines 142' define an overlap with the resist pillars 132', a metal pillar will be formed on top of a metal line.

In Figs. 3a-b, the hard mask layer 120 has been patterned by etching while using the second resist pattern 142 as an etch mask to define a hard mask line pattern 122 underneath the second resist pattern 142. The pattern defined by the second resist pattern 142 has thus been transferred into the hard mask layer 120. The hard mask line pattern 122 accordingly comprises a pattern of hard mask lines 122' corresponding to the pattern of resist lines 142' of the second resist pattern 142.

Subsequently, the metal layer 110 has been patterned by etching to define a metal line pattern 112 underneath the hard mask line pattern 122. The second resist pattern 142 may be used as an etch mask during the patterning of both the hard mask layer 120 and the metal layer 110. Thereby the resist pillars 132' overlapped may be masked during the etching of the metal layer 110. However it is also possible to remove the second resist pattern 142 subsequent to patterning the hard mask layer 120 and prior to patterning the metal layer 110, wherein the metal layer 110 may be patterned while using the hard mask line pattern 122 as an etch mask. In either case, the pattern (originally) defined by the second resist pattern 142 has thus been transferred into the metal layer 110 (i.e. via the hard mask layer 120). The metal line pattern 112 accordingly comprises a pattern of metal lines 112' corresponding to the pattern of resist lines 142' of the second resist pattern 142. For reasons which will become apparent from the below the metal lines 112' may be denoted "initial" metal lines 112'.

The hard mask layer 120 and the metal layer 110 may each be etched using conventional etching processes enabling high fidelity pattern transfer into hard mask and metal layers. The hard mask layer 120 and the metal layer 110 may be etched top-down (seen along the Z-direction) using an anisotropic dry etching process. The hard mask layer 120 and the metal layer 110 may for instance be etched using a Reactive Ion Etch (RIE) process making use of a F-based plasma and an O₂-based plasma, respectively.

Provided the second resist pattern 142 not already has been removed or consumed during the patterning, the second resist pattern 142 may as shown in Figs. 3a-b be removed. The first resist pattern 132 (i.e. the resist pillars 132' thereof) may thus be exposed. In the illustrated example, the resist pillars 132' are completely overlapped by the second resist pattern 142, and their original dimensions defined by the first lithography process are thus preserved.

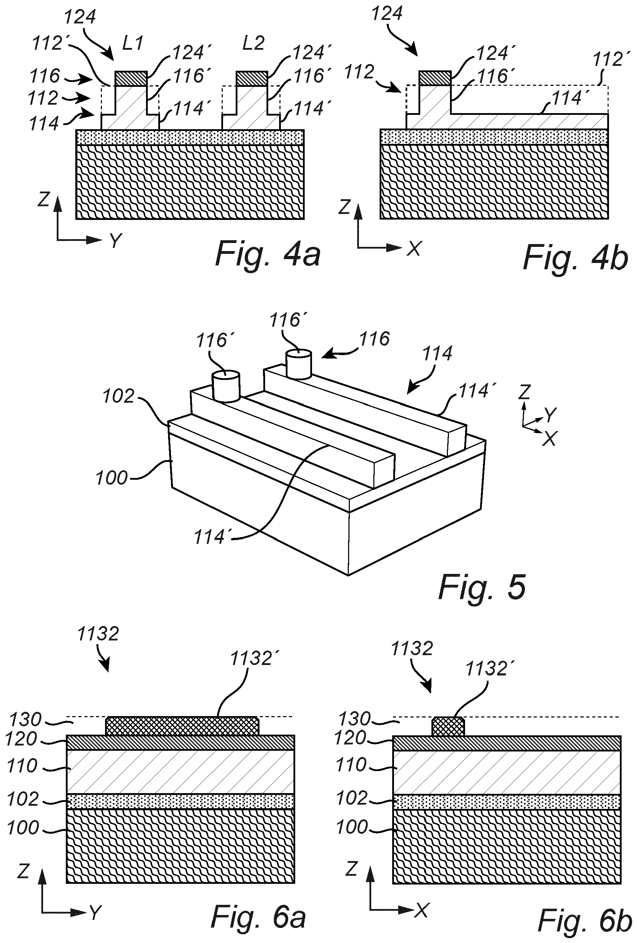

In Figs. 4a-b, the hard mask line pattern 122 has been patterned by etching while using the first resist pattern 132 as an etch mask to define a hard mask pillar pattern 124 over the metal line pattern 112. The pattern defined by the first resist pattern 132 has thus been transferred into the hard mask line pattern 122 (now a twice patterned hard mask layer 120). The hard mask pillar pattern 124 accordingly comprises a pattern of hard mask pillars 124' corresponding to the pattern of resist bars 132' of the first resist pattern 132.

Subsequently, the (initial) metal lines 112' of the metal line pattern 112 have been partially etched back using the first resist pattern 132 and the hard mask pillar pattern 124 as an etch mask (in case the first resist pattern 132 is preserved after patterning the hard mask line pattern 122) or using the hard mask pillar pattern 124 as an etch mask (in case the first resist pattern 132 has been removed or consumed after/during the patterning of the hard mask line pattern 122).

In either case, the pattern defined by the first resist pattern 132 has thus been transferred into the metal lines 112' (i.e. via the hard mask line pattern 122) to form a pattern 116 of metal pillars 116' on etched back "final" metal lines 114' of a "final" metal line pattern 114. Accordingly, the metal pillars 116' are by an upper thickness portion of initial metal lines 112' preserved underneath respective hard mask pillars 124'. The metal line pattern 114 and the metal pillar pattern 116 are hence formed from a same metal layer 110.

The amount of partial etch back determines the height of the metal pillars 116' and the height (thickness) of the remaining portion of the final metal lines 114'. As may be appreciated, the metal layer 110 should accordingly be deposited with a thickness such that final metal lines 114' and metal pillars 116' of respective desired heights may be accommodated therein. The term "partially etched back" hereby refers to that the etch back of the metal lines 112' is stopped prior to completely etching through the metal lines 112'.

The patterning of the hard mask line pattern 122 and the etch back of the initial metal lines 112' may be performed using any of the etching processes discussed above in connection with the patterning of the hard mask layer 120 and the metal layer 110.

Fig. 5 is a schematic perspective view of two metal lines 114' of the metal line pattern 114, with a respective metal pillar 116' of metal pillar pattern 116 on top. The metal line pattern 114 and the metal pillar pattern 116 may define horizontal and vertical interconnects, respectively, of an interconnect level of an interconnect structure. The method may proceed by covering the metal line pattern 114 and the metal pillar pattern 116 with insulating layer, such as one or more inter-layer dielectric materials. The insulating layer may be recessed (e.g. by CMP) to expose upper surfaces of the metal pillar pattern 116. A further metal layer corresponding to metal layer 110 may then be formed on top of the metal pillar pattern 116 wherein the above method steps may be repeated to form horizontal and vertical interconnects of a further interconnect level of the interconnect structure.

A method for forming an interconnection structure according to a second embodiment will now be disclosed with reference to Figs. 6a-b to 9a-b and 10. The method of the second embodiment involves corresponding structures and method steps as the above illustrated first embodiment, however differs by the pattern defined in the first resist layer 130.

With reference to Figs. 6a-b, the first resist layer 130 has been patterned using a first lithography process to define a first resist pattern 1132 in the form of a pattern of resist bars 1132'. The resist bars 1132' extend in parallel along the second direction Y and thus transverse to the first direction X.

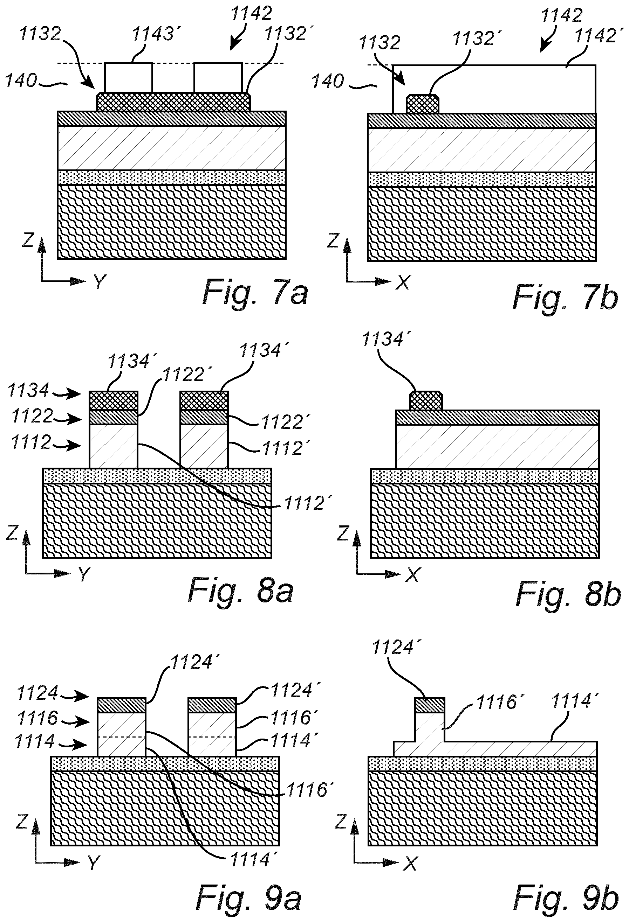

In Figs. 7a-b, the second resist layer 140 has been formed over the first resist pattern 1132 and then patterned using a second lithography process to define a second resist pattern 1142 in the form of a pattern of resist lines 1142' extending in parallel along the first direction X. The above discussion of the second resist pattern 142 applies correspondingly to the second resist pattern 1142.

Similar to the first embodiment, the positions of the resist lines 1142' of the second resist pattern 1142 define the positions (as seen in the horizontal plane XY) of the metal lines of the interconnect structure which are to be formed. However, in contrast to the first embodiment, only a portion of the first resist pattern 1132 is overlapped by the second resist pattern 1142. More specifically, the second resist pattern 1142 is formed such that each resist bar 1132' of the first resist pattern 1132 is overlapped by at least two resist lines 1142' of the second resist pattern 1142. The positions of the overlapped portions of the resist bars 1132' of the first resist pattern 1132 define the locations (as seen in the horizontal plane XY) of the metal pillars to be formed on top of the metal lines, as will become apparent from the following.

In Figs. 8a-b, the first resist pattern 1132 and the hard mask layer 120 have been patterned by etching while using the second resist pattern 1142 as an etch mask. The pattern defined by the second resist pattern 142 has thus been transferred into the hard mask layer 120, thereby defining a hard mask line pattern 1122 of hard mask lines 1122' underneath the second resist pattern 1142.

Due to the merely partial overlap between the second resist pattern 1142 and the first resist pattern 1132, the pattern is transferred into the hard mask layer 120 via the first resist pattern 1132. Hence, non-overlapped portions of the first resist pattern 1132, more specifically portions of each resist bar 1132' not overlapped by a resist line 1142', have been removed. Thereby a resist pillar pattern 1134 of resist pillars 1134' (i.e. a now twice patterned first resist layer 130) has been formed in the first resist pattern 1132. Each resist pillar 1134' is formed over a respective hard mask line 1122'. Due to the transverse orientation of the resist bars 1132' and the resist lines 1142', the resist pillars 1134' resulting from a same resist bar 1132' may be aligned with each other as seen along the second direction Y. While the illustrated example depicts only a single resist bar 1132' and two resulting resist pillars 1134', the number of aligned metal pillars formed along a resist bar 1132' is more generally determined by the number of resist lines 1142' overlapping the resist bar 1132'.

Subsequent to patterning the first resist pattern 1132 and the hard mask layer 120, the metal layer 110 has as shown been patterned by etching to define a metal line pattern 1112 of metal lines 1112' underneath the hard mask line pattern 1122. The description of the patterning of the metal layer 120 in connection with the first embodiment applies correspondingly to the second embodiment.

In Figs. 9a-b the pattern defined by the first resist pillar pattern 1134 has been transferred into the hard mask line pattern 1122, and subsequently into the metal line pattern 1112 by partially etching back the (initial) metal lines 1112' thereof. The pattern (originally) defined by the resist pillar pattern 1134 has thus been transferred into the metal lines 1112' (i.e. via the hard mask line pattern 1122) to form a pattern 1116 of metal pillars 1116' on etched back "final" metal lines 1114' of a "final" metal line pattern 1114.

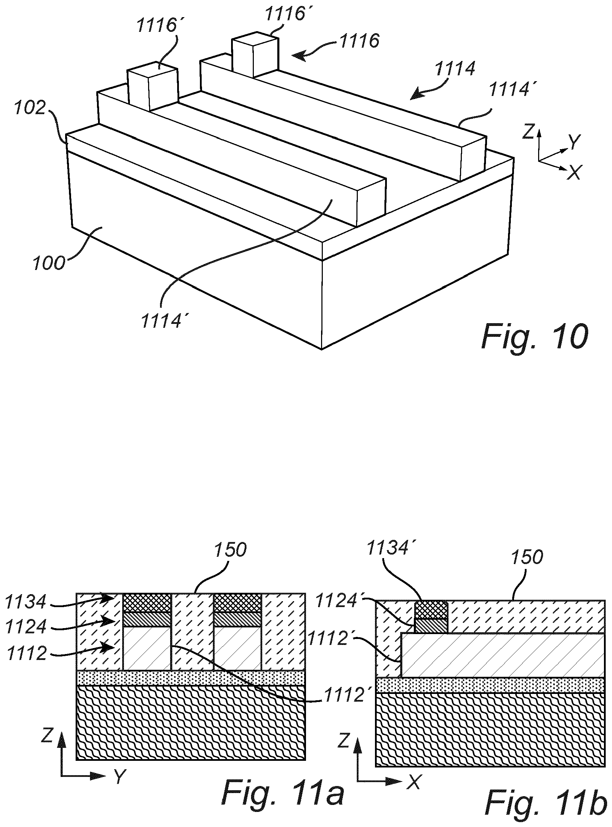

Fig. 10 is a schematic perspective view of two metal lines 1114' of the metal line pattern 1114, with a respective metal pillar 1116' of metal pillar pattern 1116 on top. The method may thereafter proceed as outlined in connection with the first embodiment.

A method for forming an interconnection structure according to a third embodiment will now be disclosed with reference to 11a-b to 13a-b.

Figs. 11a-b shows the device structure at stage corresponding to that of Figs. 8a-b wherein the hard mask line pattern 1122, the resist pillar pattern 1134 and the metal line pattern 1112 (subsequent to the patterning for forming the same) have been surrounded an insulating layer 150. The insulating layer 150 may be formed by depositing one or more inter-layer dielectric materials, such as SiO₂ or other low-k dielectric, deposited e.g. using CVD, flowable-CVD or PVD. The dielectric material(s) may subsequently be recessed (e.g. by CMP) to expose upper surfaces of the resist pillar pattern 1134 as shown. The hard mask line pattern 1122, the resist pillar pattern 1134 and the metal line pattern 1112 may thus be embedded in the insulating layer 150.

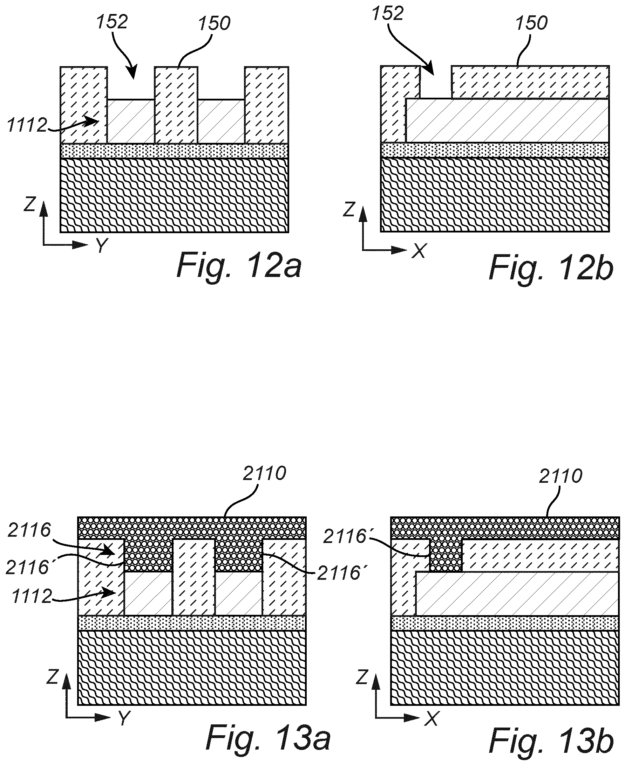

In Figs. 12a-b, the hard mask line pattern 1122, the resist pillar pattern 1134 have been removed selectively to the insulating layer 150 to form pillar openings 152 in the insulating layer 150. The hard mask line pattern and the resist pillar pattern 1134 may be removed using a suitable etching chemistry, wet or dry.

In Figs. 13a-b, a second metal layer 2110 has been deposited in the pillar openings 152 and on the insulating layer 150. The second metal layer 2110 may be formed by any of the materials and deposition techniques exemplified for the metal layer 110. The second metal layer 2110 may if needed be planarized (e.g. using CMP) to be provided with a planar upper surface. The portions of the second metal layer 2110 filling the pillar openings 152 thus form a metal pillar pattern 2116 of metal pillars 2116', defining vertical interconnects between the metal line pattern 1112 and a metal line pattern which may be formed in the second metal layer 2110. The second metal layer 2110 may be patterned in accordance with any one of the embodiments described herein.

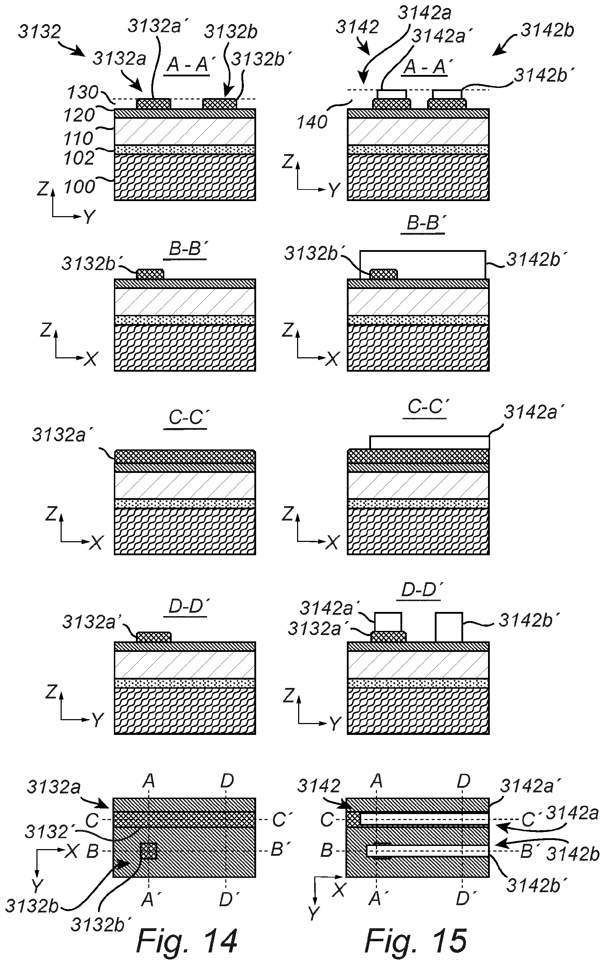

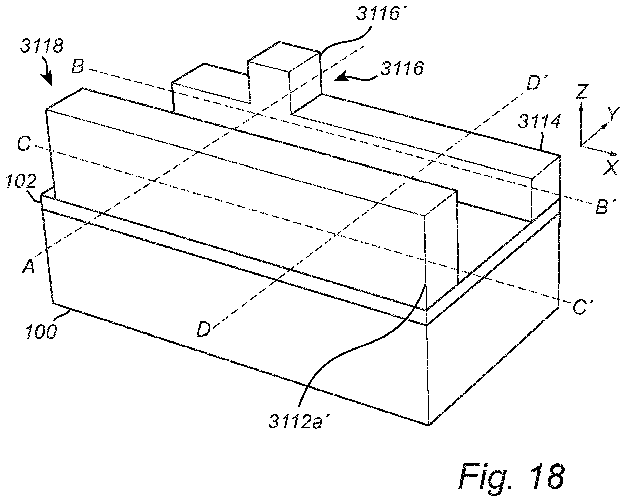

A method for forming an interconnection structure according to a fourth embodiment will now be disclosed with reference to Figs. 14 to 18. Each one of Figs. 14 to 17 show (from top-to-bottom row) a first cross sectional view along line A-A', a second cross sectional view along line B-B', a third cross sectional view along line C-C', a fourth cross sectional view along line D-D', and a top-down view. Fig. 18 show a perspective view of the resulting device structure. The fourth embodiment enables forming of a metal line pattern comprising metal lines of a height which varies between and/or along metal lines.

In contrast to the first and second embodiments, the first resist layer 130 is as shown in Fig. 14 patterned to define a first resist pattern 3132 comprising a first sub-pattern 3132a of resist lines 3132a' extending in parallel along the first direction X, and a second sub-pattern 3132b of second resist features 3132b'. In the illustrated embodiment the second sub-pattern 3132b is a pattern of resist pillars 3132b', corresponding to the resist pillars 132' of the first resist pattern 132 in accordance with the first embodiment. However, it is also possible to form the second sub-pattern 3132b as a pattern of resist bars corresponding to the resist bars 1132' of the first resist pattern 1132 in accordance with the second embodiment, wherein each resist bar may be formed to extend along the second direction Y.

In Fig. 15, a second resist layer 140 is formed over the first resist pattern 3132 and patterned to define a second resist pattern 3142 comprising a first sub-pattern 3142a of first resist lines 3142a' and a second sub-pattern 3142b of second resist lines 3142b'. The first resist lines 3142a' and the second resist lines 3142b' extend in parallel along the first direction X.

Each resist line 3132a' of the first sub-pattern 3132a of the first resist pattern 3132 is overlapped, along at least a part of its length, by a first resist line 3142a' of the first sub-pattern 3142a of the second resist pattern 3142. Each second resist feature 3132b' (e.g. resist pillar or resist bar) of the second sub-pattern 3132b of the first resist pattern 3132 is overlapped, completely or only partly (as shown), by a second resist line 3142b' of the second sub-pattern 3142b of the second resist pattern 3142.

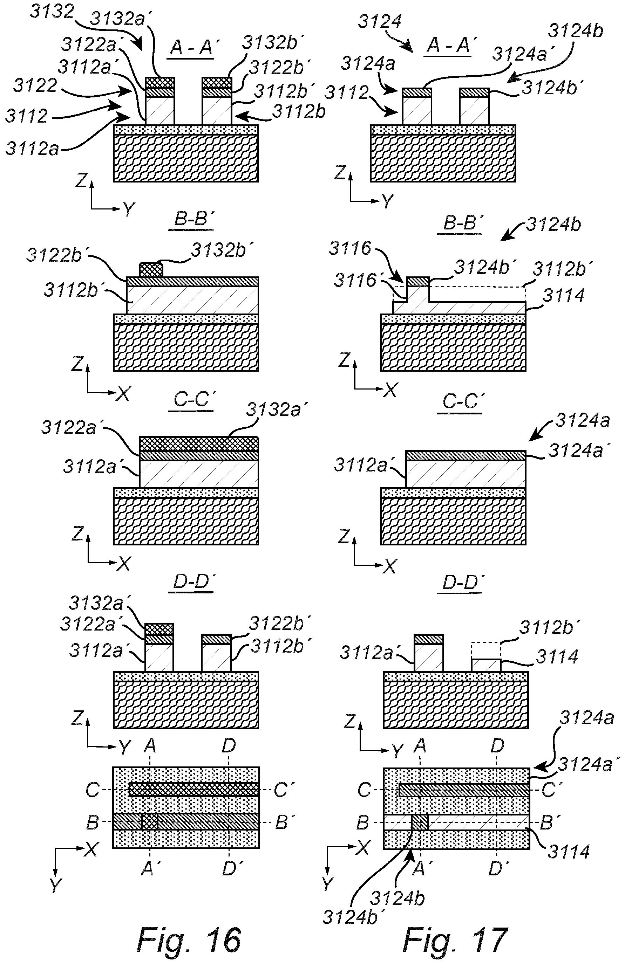

In Fig. 16, the hard mask layer 120 has been patterned by etching while using the second resist pattern 3142 as an etch mask. The pattern defined by the second resist pattern 3142 has thus been transferred into the hard mask layer 120, thereby defining a hard mask line pattern 3122 of first and second hard mask lines 3122a', 3122b' underneath the second resist pattern 3142. Due to the merely partial overlap between the second resist pattern 3142 and the first resist pattern 3132 in the illustrated embodiment, also the first resist pattern 3132 is patterned by etching using the second resist pattern 3142 as an etch mask. Consequently non-overlapped portions of the resist lines 3132a' and second resist features 3132b' may as shown be removed. Conversely, portions of the resist lines 3132a' and second resist features 3132b' overlapped respectively by first or second resist lines 3142a', 3142b' of the second resist pattern 3142 may be preserved. In the case of second resist features 3132b' in the form of resist bars, the patterning of the first resist pattern 3132 results in forming of second resist features in the form of resist pillars, in correspondence with the description of Figs. 8a-b of the second embodiment.

The illustrated embodiment shows as an example that a width dimension (along the Y direction) of the first and second resist lines 3142a', 3142b' may be smaller than a corresponding width dimension of the resist lines and resist features 3132a', 3132b. Hence, a width dimension of the resist lines and resist features 3132a', 3132b of the first resist pattern 3132 may be trimmed in accordance with the width dimensions of the first and second resist lines 3142a', 3142b'. This is however optional and it is also possible to form the first and second resist lines 3142a', 3142b' with a width dimension similar to or greater than a width dimension of the resist lines and resist features 3132a', 3132b.

Subsequent to patterning the hard mask layer 120 (and the first resist pattern 3132), the metal layer 110 has as shown been patterned by etching to define a metal line pattern 3112 underneath the hard mask line pattern 3122. The pattern (originally) defined by the second resist pattern 3142 has thus been transferred into the metal layer 110, via the hard mask layer 120 (and the first resist pattern 3132). The metal line pattern 3112 accordingly comprises a first sub-pattern 3112a of first metal lines 3112a' corresponding to the first sub-pattern 3142a of the second resist pattern 3142 and a second sub-pattern 3112b of second metal lines 3112b' corresponding to the second sub-pattern 3142b of the second resist pattern 3142.

In Fig. 17, the hard mask line pattern 3122 has been patterned by etching while using the first resist pattern 3132 defined by the (preserved portions of the) first sub-pattern 3132a of resist lines 3132a' and the second sub-pattern 3132b of second resist features 3132b' (resist pillars). Thereby, a combined hard mask pillar-and-line pattern 3124 is formed over the metal line pattern 3112. The combined hard mask pillar-and-line pattern 3124 accordingly comprises a first sub-pattern 3124a of hard mask lines 3124a' and a second sub-pattern 3124b of hard mask pillars 3124b'. Each hard mask line 3124a' is formed over a first metal line 3112a' and each hard mask pillar 3124b' is formed over a second metal line 3112b'.

Subsequently, the metal line pattern 3112 has been partially etched back using the first resist pattern 3132 and the combined hard mask pillar-and-line pattern 3124 as an etch mask (in case the first resist pattern 3132 is preserved after patterning the hard mask line pattern 3122) or using the combined hard mask pillar-and-line pattern 3124 as an etch mask (in case the first resist pattern 3132 has been removed or consumed after/during the patterning of the hard mask line pattern 3122). In either case, the pattern defined by the first resist pattern 3132 has thus been transferred into the metal line pattern 3112 (i.e. via the hard mask line pattern 3122).

More specifically, during the metal line etch back, the first metal lines 3112a' of the first sub-pattern 3112a of the metal line pattern 3112 are masked by the resist lines 3132a' of the first sub-pattern 3132a of the first resist pattern 3132 and/or the hard mask lines 3124a' of the first sub-pattern 3124a of the combined hard mask pillar-and-line pattern 3124. The original height of the first metal lines 3112a' is hence preserved after the metal line etch back.

Meanwhile, during the metal line etch back, the second metal lines 3112b' of the second sub-pattern 3112b of the metal line pattern 3112 are masked by the second resist features 3132b' of the second sub-pattern 3132b of the first resist pattern 3132 and/or the hard mask pillars 3124b' of the second sub-pattern 3124b of the combined hard mask pillar-and-line pattern 3124. The second metal lines 3112b' of the second sub-pattern 3112b of the metal line pattern 3112 are thus partially etched back in regions not masked by the second resist features 3132b' and/or the hard mask pillars 3124b' (see e.g. the cross-section along B-B'). The etched back "final" second metal lines are designated 3114. Accordingly, the pattern defined by the second resist features 3132b' of the second sub-pattern 3132b of the first resist pattern 3132 has been transferred into the second metal lines 3112b' (i.e. via the hard mask line pattern 3122) to form a pattern 3116 of metal pillars 3116' on etched back "final" second metal lines 3114.

Fig. 18 is a schematic perspective view of the first and second metal lines 3112a' and 3114 of the final metal line pattern 3118, wherein a metal pillar 3116' of metal pillar pattern 1116 is formed on top of the (partially etched-back) second metal line 3114.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for forming an interconnect structure for an integrated circuit, the method comprising:
forming a metal layer (110) over a substrate (100);
forming a hard mask layer (120, 220) over the metal layer (110);
forming a first resist layer (130) of a first resist material over the hard mask layer (120) and patterning the first resist layer (110) in a first lithography process to define a first resist pattern (132, 1132);
forming over the first resist pattern (132, 1132) a second resist layer (140) of a second resist material different from the first resist material and patterning the second resist layer (140) in a second lithography process to define a second resist pattern (142, 1142) of resist lines (142', 1142') extending in parallel along a first direction, wherein at least a portion of the first resist pattern (132, 1132) is overlapped by the second resist pattern (142, 1142);
patterning the hard mask layer (120) using the second resist pattern (142, 1142) as an etch mask to define a hard mask line pattern (122, 1122) underneath the second resist pattern (142), and subsequently the metal layer (110) to define a metal line pattern (112, 1112) underneath the hard mask line pattern (122, 122);
removing the second resist pattern (142, 1142) and subsequently patterning the hard mask line pattern (122, 1122) using said at least a portion of the first resist pattern (132, 1132) as an etch mask to define a hard mask pillar pattern (124, 1124) over the metal line pattern (112, 1112); and
forming a metal pillar pattern (116, 1116, 2116) in accordance with the hard mask pillar pattern (124).

2. A method according to claim 1, wherein only a portion of the first resist pattern (132, 1132) is overlapped by the second resist pattern (142, 1142).

3. A method according to claim 2, further comprising patterning the first resist pattern (1132) using the second resist pattern (142) as an etch mask.

4. A method according to any one of the preceding claims, wherein the first resist pattern (132) comprises a pattern of resist pillars (132'), and wherein the second resist layer (140) is patterned such that at least a portion of each resist pillar (132') is overlapped by a resist line (142') of the second resist pattern (142).

5. A method according to any one of the preceding claims, wherein the first resist pattern (1132) comprises a pattern of resist bars (1132') extending in parallel along a second direction transverse to the first direction, and wherein the second resist layer (140) is patterned such that each respective resist bar (1132') of the first resist pattern (1132) is overlapped by at least two resist lines (1142') of the second resist pattern (1142).

6. A method according to any one of the preceding claims, wherein forming the metal pillar pattern (116, 1116) comprises partially etching back the metal line pattern (112, 1112) using said at least a portion of the first resist pattern (132, 1132) and/or the hard mask pillar pattern (124, 1124) as an etch mask.

7. A method according to any one of claims 1-5, further comprising forming an insulating layer (150) surrounding the metal line pattern (1112) and the hard mask pillar pattern (1124), and wherein forming the metal pillar pattern (2116) comprises removing the hard mask pillar pattern (1124) to form pillar openings (152) in the insulating layer (150), and depositing a second metal layer (2110) in the pillar openings (152).

8. A method according to claim 7, further comprising surrounding said at least a portion of the first resist pattern (1134) with the insulating layer (150) and removing both the hard mask pillar pattern (1124) and said at least a portion of the first resist pattern (1134) to form the pillar openings (152) in the insulating layer (150).

9. A method according to any one claims 1-6,
wherein the first resist pattern (3132) comprises a first sub-pattern (3132a) of resist lines (3132a') extending in parallel along the first direction, and a second sub-pattern (3132b) of second resist features (3132b'),
wherein the second resist layer (140) is patterned such that each respective resist line (3132a') of the first sub-pattern (3132a), along at least a part of its length, is overlapped by a respective first resist line (3142a) of the second resist pattern (3142), and such that at least a portion of each second resist feature (3132b') of the second sub-pattern (3132b) is overlapped by a respective second resist line (3142b') of the second resist pattern (3142),
wherein said at least a portion of the first resist pattern (3132) used as the etch mask when patterning the hard mask line pattern (3122) comprises: said at least a part of each resist line (3132a') of the first sub-pattern (3132a) and said at least a portion of each second resist feature (3132b') of the second sub-pattern (3132b), and
wherein the method comprises, subsequent to removing the second resist pattern (3142), patterning the hard mask line pattern (3122) using said at least a portion of the first resist pattern (3132) as an etch mask to define a combined hard mask pillar-and-line pattern (3124) over the metal line pattern (3112), and subsequently partially etching back the metal line pattern (3112) using said at least a portion of the first resist pattern (3132) and/or the combined hard mask pillar-and-line pattern (3124) as an etch mask.

10. A method according to claim 9, wherein the second sub-pattern (3132b) is a pattern of resist pillars (3132b'), or a pattern of resist bars extending in parallel along a second direction transverse to the first direction.

11. A method according to any one of the preceding claims, wherein the first resist material is a metal-comprising resist material, and the second resist material is an organic resist material, or vice versa.

12. A method according to claim 11, wherein the organic resist material is a chemically amplified resist material.

13. A method according to any one of claims 11 or 12, wherein the first resist material is a metal-comprising resist material, and the second resist material is an organic resist material.

14. A method according to claim 13, wherein the second resist layer (140) is formed with a greater thickness than the first resist layer (130).

## Patentansprüche

1. Verfahren zum Bilden einer Zusammenschaltungsstruktur für eine integrierte Schaltung, wobei das Verfahren umfasst:
Bilden einer Metallschicht (110) über einem Substrat (100);
Bilden einer Hartmaskenschicht (120, 220) über der Metallschicht (110);
Bilden einer ersten Resist-Schicht (130) aus einem ersten Resist-Material über der Hartmaskenschicht (120) und Strukturieren der ersten Resist-Schicht (110) in einem ersten Lithographieprozess, um ein erstes Resist-Muster (132, 1132) zu definieren;
Bilden über dem ersten Resist-Muster (132, 1132) einer zweiten Resist-Schicht (140) aus einem zweiten Resist-Material, das anders als das erste Resist-Material ist, und Strukturieren der zweiten Resist-Schicht (140) in einem zweiten Lithographieprozess, um ein zweites Resist-Muster (142, 1142) aus Resist-Linien (142', 1142'), die sich parallel entlang einer ersten Richtung erstrecken, zu definieren, wobei sich mindestens ein Abschnitt des ersten Resist-Musters (132, 1132) mit dem zweiten Resist-Muster (142, 1142) überlappt;
Strukturieren der Hartmaskenschicht (120) unter Verwendung des zweiten Resist-Musters (142, 1142) als Ätzmaske, um ein Hartmaskenlinienmuster (122, 1122) unterhalb des zweiten Resist-Musters (142) zu definieren, und anschließend der Metallschicht (110), um ein Metalllinienmuster (112, 1112) unterhalb des Hartmaskenlinienmusters (122, 122) zu definieren;
Entfernen des zweiten Resist-Musters (142, 1142), und anschließend Strukturieren des Hartmaskenlinienmusters (122, 1122) unter Verwendung mindestens eines Abschnitts des ersten Resist-Musters (132, 1132) als Ätzmaske, um ein Hartmaskenstützenmuster (124, 1124) über dem Metalllinienmuster (112, 1112) zu definieren; und
Bilden eines Metallstützenmusters (116, 1116, 2116) gemäß dem Hartmaskenstützenmuster (124).

2. Verfahren nach Anspruch 1, wobei sich nur ein Abschnitt des ersten Resist-Musters (132, 1132) mit dem zweiten Resist-Muster (142, 1142) überlappt.

3. Verfahren nach Anspruch 2, ferner umfassend das Strukturieren des ersten Resist-Musters (1132) unter Verwendung des zweiten Resist-Musters (142) als Ätzmaske.

4. Verfahren nach einem der vorhergehenden Ansprüche, wobei das erste Resist-Muster (132) ein Muster aus Resist-Stützen (132') umfasst, und wobei die zweite Resist-Schicht (140) derart strukturiert ist, dass sich mindestens ein Teil jeder Resist-Stütze (132') mit einer Resist-Linie (142') des zweiten Resist-Musters (142) überlappt.

5. Verfahren nach einem der vorhergehenden Ansprüche, wobei das erste Resist-Muster (1132) ein Muster aus Resist-Stäben (1132') umfasst, das sich parallel entlang einer zweiten Richtung, die zu der ersten Richtung quer liegt, erstreckt, und wobei die zweite Resist-Schicht (140) derart strukturiert ist, dass sich jeder jeweilige Resist-Stab (1132') des ersten Resist-Musters (1132) mit mindestens zwei Resist-Linien (1142') des zweiten Resist-Musters (1142) überlappt.

6. Verfahren nach einem der vorhergehenden Ansprüche, wobei das Bilden des metallischen Stützenmusters (116, 1116) das teilweise Rückätzen des metallischen Linienmusters (112, 1112) unter Verwendung des mindestens einen Abschnitts des ersten Resist-Musters (132, 1132) und/oder des Hartmasken-Stützenmusters (124, 1124) als Ätzmaske umfasst.

7. Verfahren nach einem der Ansprüche 1 bis 5, ferner umfassend das Bilden einer Isolierschicht (150), die das metallische Linienmuster (1112) und das Hartmasken-Stützenmuster (1124) umgibt, und wobei das Bilden des metallischen Stützenmusters (2116) das Entfernen des Hartmasken-Stützenmusters (1124), um Stützenöffnungen (152) in der Isolierschicht (150) zu bilden, und das Abscheiden einer zweiten Metallschicht (2110) in den Stützenöffnungen (152) umfasst.

8. Verfahren nach Anspruch 7, ferner umfassend das Umgeben des mindestens einen Abschnitts des ersten Resist-Musters (1134) mit der Isolierschicht (150) und das Entfernen sowohl des Hartmasken-Stützenmusters (1124) als auch mindestens eines Abschnitts des ersten Resist-Musters (1134), um die Stützenöffnungen (152) in der Isolierschicht (150) zu bilden.

9. Verfahren nach einem der Ansprüche 1 bis 6,
wobei das erste Resist-Muster (3132) ein erstes Teilmuster (3132a) aus Resist-Linien (3132a'), die sich parallel entlang der ersten Richtung erstrecken, und ein zweites Teilmuster (3132b) aus zweiten Resist-Merkmalen (3132b') umfasst,
wobei die zweite Resist-Schicht (140) derart strukturiert ist, dass jede jeweilige Resist-Linie (3132a') des ersten Teilmusters (3132a) sich entlang mindestens eines Teils ihrer Länge mit einer jeweiligen ersten Resist-Linie (3142a) des zweiten Resist-Musters (3142) überlappt, und derart, dass sich mindestens ein Abschnitt jedes zweiten Resist-Merkmals (3132b') des zweiten Teilmusters (3132b) mit einer jeweiligen zweiten Resist-Linie (3142b') des zweiten Resist-Musters (3142) überlappt,
wobei der mindestens eine Abschnitt des ersten Resist-Musters (3132), der als Ätzmaske verwendet wird, wenn das HartmaskenLinienmuster (3122) strukturiert wird, umfasst: den mindestens einen Teil jeder Resist-Linie (3132a') des ersten Teilmusters (3132a) und den mindestens einen Abschnitt jedes zweiten Resist-Merkmals (3132b') des zweiten Teilmusters (3132b), und
wobei das Verfahren nach dem Entfernen des zweiten Resist-Musters (3142) das Strukturieren des Hartmasken-Linienmusters (3122) unter Verwendung des mindestens einen Abschnitts des ersten Resist-Musters (3132) als Ätzmaske, um ein kombiniertes Hartmasken-Stützen- und Linienmuster (3124) über dem metallischen Linienmuster (3112) zu definieren, und anschließend das teilweise Rückätzen des metallischen Linienmusters (3112) unter Verwendung des mindestens einen Abschnitts des ersten Resist-Musters (3132) und/oder des kombinierten Hartmasken-Stützen- und Linienmusters (3124) als Ätzmaske umfasst.

10. Verfahren nach Anspruch 9, wobei das zweite Teilmuster (3132b) ein Muster aus Resist-Stützen (3132b') oder ein Muster aus Resist-Stäben, die sich parallel entlang einer zweiten Richtung, die zu der ersten Richtung quer liegt, erstrecken, ist.

11. Verfahren nach einem der vorhergehenden Ansprüche, wobei das erste Resist-Material ein metallhaltiges Resist-Material ist, und das zweite Resist-Material ein organisches Resist-Material ist oder umgekehrt.

12. Verfahren nach Anspruch 11, wobei das organische Resist-Material ein chemisch verstärktes Resist-Material ist.

13. Verfahren nach einem der Ansprüche 11 oder 12, wobei das erste Resist-Material ein metallhaltiges Resist-Material ist, und das zweite Resist-Material ein organisches Resist-Material ist.

14. Verfahren nach Anspruch 13, wobei die zweite Resist-Schicht (140) mit einer größeren Dicke als die erste Resist-Schicht (130) gebildet wird.

## Revendications

1. Procédé de formation d'une structure d'interconnexion pour un circuit intégré, le procédé comprenant :
la formation d'une couche métallique (110) sur un substrat (100) ;
la formation d'une couche de masque dur (120, 220) sur la couche métallique (110) ;
la formation d'une première couche de résine (130) d'un premier matériau de résine sur la couche de masque dur (120) et la formation de motifs sur la première couche de résine (110) dans un premier processus de lithographie pour définir un premier motif de résine (132, 1132) ;
la formation sur le premier motif de résine (132, 1132) d'une deuxième couche de résine (140) d'un deuxième matériau de résine différent du premier matériau de résine et la formation de motifs sur la deuxième couche de résine (140) dans un deuxième processus de lithographie pour définir un deuxième motif de résine (142, 1142) de lignes de résine (142', 1142') s'étendant en parallèle le long d'une première direction, dans lequel au moins une partie du premier motif de résine (132, 1132) est chevauchée par le deuxième motif de résine (142, 1142) ;
la formation de motifs sur la couche de masque dur (120) en utilisant le deuxième motif de résine (142, 1142) comme masque de gravure pour définir un motif de ligne de masque dur (122, 1122) sous le deuxième motif de résine (142), puis sur la couche métallique (110) pour définir un motif de ligne métallique (112, 1112) sous le motif de ligne de masque dur (122, 122) ;
le retrait du deuxième motif de résine (142, 1142) puis la formation de motifs sur le motif de ligne de masque dur (122, 1122) en utilisant au moins une partie du premier motif de résine (132, 1132) comme masque de gravure pour définir un motif de pilier de masque dur (124, 1124) sur le motif de ligne métallique (112, 1112) ; et
la formation d'un motif de pilier métallique (116, 1116, 2116) conformément au motif de pilier de masque dur (124).

2. Procédé selon la revendication 1, dans lequel seule une partie du premier motif de résine (132, 1132) est recouverte par le deuxième motif de résine (142, 1142).

3. Procédé selon la revendication 2, comprenant en outre la formation de motifs sur le premier motif de résine (1132) en utilisant le deuxième motif de résine (142) comme masque de gravure.

4. Procédé selon une quelconque des revendications précédentes, dans lequel le premier motif de résine (132) comprend un motif de pilier de résine (132'), et dans lequel la deuxième couche de résine (140) est structurée de telle sorte qu'au moins une partie de chaque pilier de résine (132') soit recouverte par une ligne de résine (142') du deuxième motif de résine (142).

5. Procédé selon une quelconque des revendications précédentes, dans lequel le premier motif de résine (1132) comprend un motif de barres de résine (1132') s'étendant en parallèle le long d'une deuxième direction transversale à la première direction, et dans lequel la deuxième couche de résine (140) est structurée de telle sorte que chaque barre de résine respective (1132') du premier motif de résine (1132) soit recouverte par au moins deux lignes de résine (1142') du deuxième motif de résine (1142).

6. Procédé selon une quelconque des revendications précédentes, dans lequel la formation du motif de pilier métallique (116, 1116) comprend la gravure partielle du motif de ligne métallique (112, 1112) en utilisant au moins une partie du premier motif de résine (132, 1132) et/ou le motif de pilier de masque dur (124, 1124) comme masque de gravure.

7. Procédé selon une quelconque des revendications 1 à 5, comprenant en outre la formation d'une couche isolante (150) entourant le motif de ligne métalliques (1112) et le motif de pilier de masque dur (1124), et dans lequel la formation du motif de pilier métalliques (2116) comprend le retrait du motif de pilier de masque dur (1124) pour former des ouvertures de piliers (152) dans la couche isolante (150), et le dépôt d'une deuxième couche métallique (2110) dans les ouvertures de piliers (152).

8. Procédé selon la revendication 7, comprenant en outre l'entourage de ladite au moins une partie du premier motif de résine (1134) avec la couche isolante (150) et le retrait du motif de pilier de masque dur (1124) et de ladite au moins une partie du premier motif de résine (1134) pour former les ouvertures de pilier (152) dans la couche isolante (150).

9. Procédé selon une quelconque des revendications 1 à 6,
dans lequel le premier motif de résine (3132) comprend un premier sous-motif (3132a) de lignes de résine (3132a') s'étendant en parallèle le long de la première direction, et un deuxième sous-motif (3132b) de deuxièmes éléments de résine (3132b'),
dans lequel la deuxième couche de résine (140) est structurée de telle sorte que chaque ligne de résine respective (3132a') du premier sous-motif (3132a), sur au moins une partie de sa longueur, soit recouverte par une première ligne de résine respective (3142a) du deuxième motif de résine (3142), et de telle sorte qu'au moins une partie de chaque deuxième élément de résine (3132b') du deuxième sous-motif (3132b) soit recouverte par une deuxième ligne de résine respective (3142b') du deuxième motif de résine (3142),
dans lequel ladite au moins une partie du premier motif de résine (3132) utilisé comme masque de gravure lors de la formation du motif de ligne de masque dur (3122) comprend : ladite au moins une partie de chaque ligne de résine (3132a') du premier sous-motif (3132a) et ladite au moins une partie de chaque deuxième élément de résine (3132b') du deuxième sous-motif (3132b), et
dans lequel le procédé comprend, après avoir retiré le deuxième motif de résine (3142), de former le motif de ligne de masque dur (3122) en utilisant au moins une partie du premier motif de résine (3132) comme masque de gravure pour définir un motif de pilier et de ligne de masque dur combiné (3124) sur le motif de ligne métallique (3112), et ensuite de graver partiellement le motif de ligne métallique (3112) en utilisant au moins une partie du premier motif de résine (3132) et/ou le motif de pilier et de ligne de masque dur combiné (3124) comme masque de gravure.

10. Procédé selon la revendication 9, dans lequel le deuxième sous-motif (3132b) est un motif de pilier de résine (3132b'), ou un motif de barres de résine s'étendant en parallèle le long d'une deuxième direction transversale à la première direction.

11. Procédé selon une quelconque des revendications précédentes, dans lequel le premier matériau de résine est un matériau de résine comprenant du métal et le deuxième matériau de résine est un matériau de résine organique, ou vice versa.

12. Procédé selon la revendication 11, dans lequel le matériau de résine organique est un matériau de résine chimiquement amplifié.

13. Procédé selon une quelconque des revendications 11 ou 12, dans lequel le premier matériau de résine est un matériau de résine comprenant du métal et le deuxième matériau de résine est un matériau de résine organique.

14. Procédé selon la revendication 13, dans lequel la deuxième couche de résine (140) est formée avec une épaisseur plus grande que la première couche de résine (130).
